# EUROPÄISCHE PATENTSCHRIFT

(11) **EP 0 868 023 B1**
(45) Veröffentlichungstag und Bekanntmachung des Hinweises auf die Patenterteilung: **18.12.2002**
(21) Anmeldenummer: 98105138.6
(22) Anmeldetag: 20.03.1998
(51) Int. Cl.: H03F 3/45

(54) **Komparator für grossen Versorgungsspannungsbereich**
Comparator for wide supply voltage range
Comparateur pour large gamme de tension d'alimentation

(30) Priorität: 27.03.1997 DE 19713144
(43) Veröffentlichungstag der Anmeldung: 30.09.1998
(73) Patentinhaber: Infineon Technologies AG, 81669 München (DE)
(72) Erfinder: Kuttner, Franz, 9524 St. Ulrich (AT)
(74) Vertreter: Graf Lambsdorff, Matthias, Dr.

(56) Entgegenhaltungen:
- EP-A- 0 407 859
- US-A- 4 264 872
- US-A- 4 450 368
- B.J. MCCARROLL ET AL: "A High-speed CMOS Comparator for Use in an ADC" IEEE JOURNAL OF SOLID-STATE CIRCUITS., Bd. 23, Nr. 1, Februar 1988, NEW YORK US, Seiten 159-165, XP002069191

## Beschreibung

Die vorliegende Erfindung betrifft einen Komparator für einen großen Versorgungsspannungsbereich, bei dem einer Differenzverstärkerstufe ein Sourcefolger nachgeschaltet ist und ein Schalter eine Rückkopplung vom Sourcefolger zur Differenzverstärkerstufe schließt.

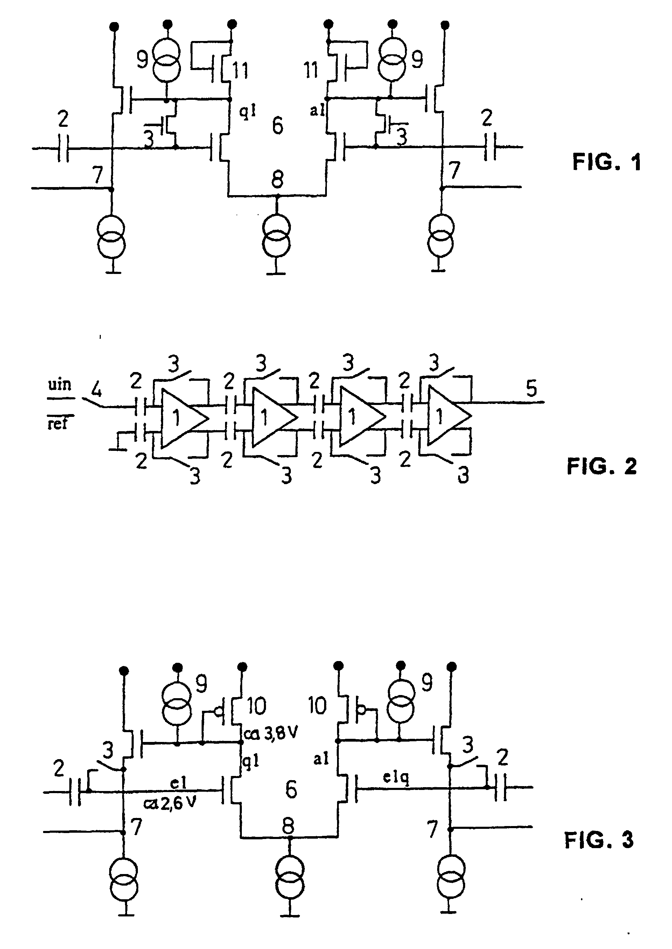

Komparatoren werden in der Elektronik bekanntlich zum Dekodieren benutzt, ob eine Spannung größer oder kleiner als eine Vergleichsspannung ist. So werden beispielsweise in A/D-Wandlern nach dem Prinzip einer sukzessiven Approximation mehrstufige Komparatoren eingesetzt, wie diese schematisch in Fig. 2 gezeigt sind, in welcher Komparatorstufen 1 über Kondensatoren 2 in Reihe geschaltet sind. Während einer Abtast- bzw. Sample-Phase sind Rückkoppelschalter 3, die die einzelnen Komparatorstufen 1 überbrücken, geschlossen, während an einem Eingang 4 eine Eingangsspannung uin anliegt. Die Versetzungsgröße (Offset) der einzelnen Komparatorstufen 1 und die zu messende Spannung uin werden in den Kondensatoren 2 abgespeichert. Während eines derartigen Betriebes setzt jede einzelne Stufe ihren eigenen Arbeitspunkt, während die Verstärkung infolge der Überbrückung der Komparatoren mittels der Schalter 3 den Wert Null hat.

In einem Sample-Zeitpunkt werden sodann alle Rückkoppelschalter 3 geöffnet und eine Vergleichsspannung ref am Eingang 4 angelegt. Jede Komparatorstufe 1 verstärkt so die Differenz der Spannungen uin und ref um etwa einen Faktor 10. Dadurch wird erreicht, daß eine kleine Differenz am Eingang 4 einen von einer nachgeschalteten Logik verarbeitbaren Spannungspegel an einem Ausgang 5 der letzten Komparatorstufe 3 antrifft.

Solche mehrstufigen Komparatoren sind beispielsweise in IEEE Journal of Solid-State Circuits, Vol. SC-17, No. 6, Dec. 1982; Vol. 27, No. 12, Dec. 1992 und EP 0407859 B1 beschrieben.

Die einzelnen Stufen des in Fig. 2 gezeigten Komparators wurden bisher als Differenzverstärkerstufe mit einem nachgeschalteten Sourcefolger ausgeführt, wie dies in Fig. 3 gezeigt ist. So ist in Fig. 3 eine Differenzverstärkerstufe 6 eingangsseitig und aussgangsseitig mit einem Sourcefolger 7 verbunden. Bei einer solchen Schaltungsanordnung hat sich gezeigt, daß der an einem Fußpunkt 8 des Differenzverstärkers 6 hineingespiegelte Strom um etwa 20 % größer als die Summe der Ströme ist, die durch zwei obere Stromquellen 9 eingeprägt werden. Die restlichen 20 % des Stromes werden von zwei PMOS-Dioden 10 übernommen.

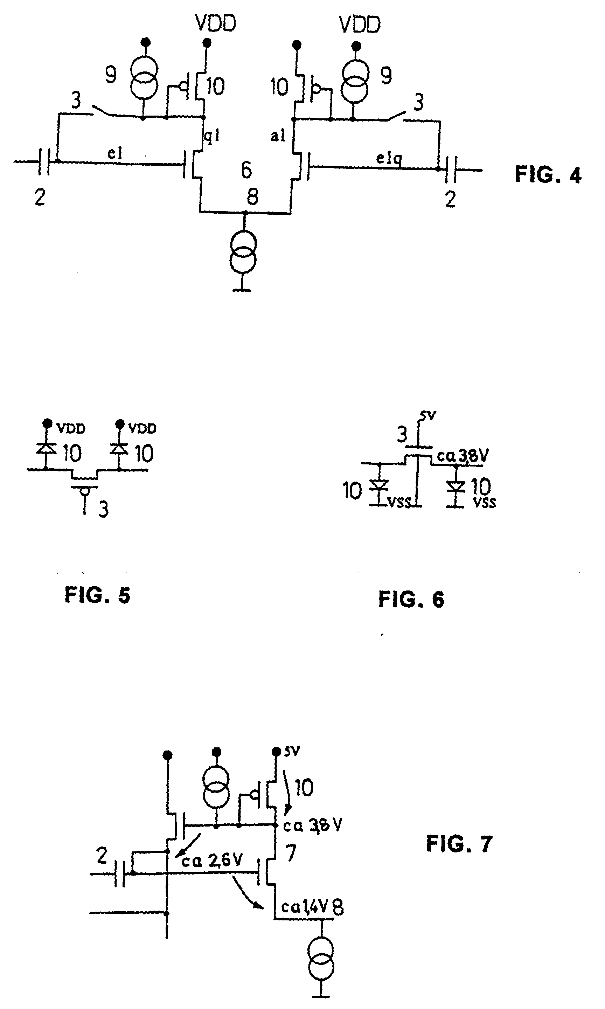

Die Struktur der in Fig. 3 gezeigten Schaltungsanordnung wurde aus einer einfachen Differenzstufe entwickelt, wie diese in Fig. 4 gezeigt ist.

Das Problem eines derartigen Differenzverstärkers sind die Schalter 3, mit denen man eine Rückkopplung des Differenzverstärkers 6 schließt.

Bei A/D-Wandlern, die nach dem Prinzip einer sukzessiven Approximation arbeiten, wie dieses anhand der Fig. 2 erläutert wurde, muß nämlich davon ausgegangen werden, daß bei der Wandlung am Eingang einer Komparatorstufe 1 ein positiver oder negativer Spannungssprung von mindestens der halben Vergleichsspannung ref auftreten kann. Bei einer Eingangsspannung uin von VDD = 5 V und einer Vergleichsspannung ref mit Vref = 5 V muß der Komparator einen Sprung von 2,5 V am Eingang 4 verarbeiten können. Beim Differenzverstärker 6 liegt der Arbeitspunkt eines Knotens a1 bzw. eines Knoten q1 nach dem Offset-Abgleich bei etwa 3,8 V, nämlich der Differenz zwischen der Spannung VDD und der Einsatzspannung der PMOS-Diode 10, wobei dieser Arbeitspunkt durch die PMOS-Diode 10 festgeklemmt ist.

Wird nun ein PMOS-Transistor für den Schalter 3 verwendet, so wird ein positiver Spannungssprung am Eingang 4 zum Problem, weil die Dioden 10 an Source bzw. Drain des Transistors (Schalters 3) leitend werden, wie dies schematisch in Fig. 5 veranschaulicht ist. Dadurch fließt von einem Knoten e1 nach dem positiven oder negativen Spannungssprung so lange Ladung ab, bis das Potential an dem Knoten e1 kleiner als die Summe aus der Spannung VDD und der Diodendurchlaßspannung ist. Nachfolgende Komparatorentscheidungen werden daher bei einer sukzessiven Approximation falsch, so daß auch das Wandlungsergebnis nicht mehr richtig ist.

Bei der Verwendung eines NMOS-Transistors als Schalter 3 tritt dieses Problem eines Spannungssprunges nicht auf, da die Dioden 10 lediglich gegen Massespannung VSS wirksam werden können, was wiederum jedoch Probleme mit einem Substratsteuereffekt des NMOS-Transistors, der als Schalter 3 dient, hervorruft.

Bei einer derartigen, in Fig. 6 gezeigten Schaltung liegt der Halbleiterkörper (Bulk) des Schalters 3 an der Massespannung VSS, während Source und Drain mit der Differenz zwischen der Spannung VDD und einer Schwellenwertspannung Vth beaufschlagt sind. Unter diesen Bedingungen ist der Schalter 3 auch dann hochohmig, wenn 5 V an seinem Gateanschluß anliegen.

Um nun diese Schalterprobleme zu lösen, wurden bisher dem Differenzverstärker 6 der Sourcefolger 7 nachgeschaltet, und die Sample-Phase wurde über beide Stufen, also den Differenzverstärker 6 und den Sourcefolger 7, rückgekoppelt. Infolge dieses Sourcefolgers 7 ist der Arbeitspunkt am Knoten e1 bzw. elq um die Schwellenwertspannung Vth niedriger als die Spannung am Knoten a1 bzw. am Knoten q1.

Soll nun der Komparator in einem großen Versorgungsspannungsbereich befriedigend arbeiten, so ist eine Schaltungsanordnung mit einem nachgeschalteten Sourcefolger 7 wenig brauchbar.

Bei einem A/D-Wandler für ein schnurloses Telefon (DECT-System) kann durch ben Batteriebetrieb die Betriebsspannung VDD zwischen 2,8 V und 5,4 V schwanken. Die Lösung mit einem nachgeschalteten Sourcefolger 7 kann hier nicht befriedigend angewandt werden, da durch die PMOS-Diode 10, den Sourcefolger und die Eingangstransistoren des Differenzverstärkers 6 drei Transistoren in Reihe zwischen der Spannung VDD und der Spannung VSS geschaltet sind, wie dies in Fig. 7 veranschaulicht ist.

Bei den durch diese Technologie gegebenen Einsatzspannungen von ca. 1 V für die einzelnen Transistoren werden so für diese Transistoren insgesamt bereits 3 V benötigt. Für die Stromquelle am Fußpunkt 8 des Differenzverstärkers 6 werden außerdem noch einmal mindestens etwa 0,5 V gewünscht. Mit einer Versorgungsspannung von etwa 2,8 V kann also ein derartiger Komparator nicht betrieben werden.

Es ist daher **Aufgabe** der vorliegenden Erfindung, einen Komparator für einen großen Versorgungsspannungsbereich zu schaffen, der zur Arbeitspunkteinstellung möglichst wenig Einsatzspannung zwischen Betriebsspannung und Massespannung benötigt.

Zur Lösung dieser Aufgabe sieht die vorliegende Erfindung bei einem Komparator der eingangs genannten Art erfindungsgemäß vor, daß zur Arbeitspunkteinstellung der Differenzverstärkerstufe eine Diode des gleichen Leitfähigkeitstyps wie der Leitfähigkeitstyp des als Schalter dienenden Transistors vorgesehen ist.

Für diese Diode kann in zweckmäßiger Weise eine NMOS-Diode verwendet werden, die zwischen Gate des Sourcefolger-Transistors und der Versorgungsspannung liegt.

Damit durch den Substratsteuereffekt der als Schalter benutzte NMOS-Transistor in der Sample-Phase nicht hochohmig wird, wird so der Arbeitspunkt an den Knoten a1 und q1 nicht mehr durch eine PMOS-Diode bestimmt. Vielmehr hat die eingesetzte NMOS-Diode den Vorteil, daß sich hier der Substratsteuereffekt gleich auswirkt wie bei dem Schalter. Bei steigender Versorgungsspannung steigt also der Arbeitspunkt nicht so stark wie die Spannung VDD an. Bei steigender Versorgungsspannung steigt der Spannungsabfall über die NMOS-Diode durch den Substratsteuereffekt. Solange also die NMOS-Diode leitet, ist auch der als Schalter arbeitende Transistor niederohmig genug, da an beiden Bauelementen in der Rückkopplungsphase die gleichen Potentiale anliegen. Bei niedrigen Versorgungsspannungen wird so ein Transistor bzw. eine Schwellenwertspannung zwischen den Spannungen VDD und VSS eingespart, so daß der Komparator bei Spannungen VDD bis herab zu ca. 2,5 V zufriedenstellend arbeiten kann.

Der Differenzverstärkerstufe sind wieder Sourcefolger nachgeschaltet, die die kapazitive Last des Koppelkondensators zur nächsten Stufe treiben. Die Versetzung bzw. der Offset dieser Sourcefolger wird nicht mehr in der Verstärkerstufe selbst kompensiert, da die Sourcefolger nicht mehr in der Rückkopplungsschleife liegen. Allerdings wird bei der beschriebenen Schaltungsanordnung eine Versetzung bzw. ein Offset, die bzw. der am Ausgang einer Stufe anliegt, in der Rückkopplungsphase in den Kondensatoren zur nächsten Stufe gespeichert und dadurch kompensiert.

Nachfolgend wird die Erfindung anhand der Zeichnung näher erläutert. Es zeigen:
- Fig. 1: eine Schaltungsanordnung des erfindungsgemäßen Komparators, und
- Fig. 2 bis Fig. 7: Schaltungsanordnungen zur Erläuterung bestehender Komparatoren.

Die Fig. 2 bis 7 wurden bereits eingangs erläutert.

In der Fig. 1 sind einander entsprechende Bauteile mit den gleichen Bezugszeichen versehen wie in den Fig. 2 bis 7.

Bei dem erfindungsgemäßen Komparator wird der Arbeitspunkt an den Knoten a1 und q1 nicht mehr durch eine PMOS-Diode, wie in der Schaltungsanordnung von Fig. 3, sondern durch eine NMOS-Diode 11 bestimmt, was den Vorteil hat, daß sich der Substratsteuereffekt in gleicher Weise auswirkt wie bei dem als Schalter 3 dienenden NMOS-Transistor. Bei steigender Versorgungsspannung VDD steigt der Arbeitspunkt damit nicht mehr so stark an wie die Versorgungsspannung. Vielmehr wächst der Spannungsabfall über der NMOS-Diode 11 durch den Substratsteuereffekt. Solange also die NMOS-Diode 11 leitet, solange ist auch der als Schalter 3 dienende NMOS-Transistor niederohmig genug, da an beiden Bauelementen, nämlich der NMOS-Diode und dem NMOS-Transistor die gleichen Potentiale anliegen.

Bei niedrigen Versorgungsspannungen kann dadurch ein Transistor bzw. eine Schwellwertspannung zwischen den Spannungen VDD und VSS eingespart werden, so daß die Funktion des Komparators bis herab zu Spannungen von 2,5 V gewährleistet ist.

Wie der bestehenden Schaltungsanordnung von Fig. 3 ist auch dem Differenzverstärker 6 ein Sourcefolger 7 nachgeschaltet, der die kapazitive Last des Koppelkondensators 2 zur nächsten Stufe treibt. Die Versetzung bzw. der Offset des Sourcefolgers 7 wird aber nicht mehr in der gleichen Stufe selbst kompensiert, da der Sourcefolger 7 nicht mehr in der rückgekoppelten Schleife liegt. Vielmehr wird bei dem erfindungsgemäßen Komparator eine Versetzung bzw. ein Offset, die bzw. der an einer Stufe anliegt, in der Rückkopplungsphase in den Kondensatoren 2 zur nächsten Stufe gespeichert und dadurch kompensiert.

## Patentansprüche

1. Komparator für großen Versorgungsspannungsbereich, bei dem einer Differenzverstärkerstufe (6) ein Sourcefolger (7) nachgeschaltet ist und ein Schalter (3) eine Rückkopplungsschleife zwischen einem Ausgang (a1, q1) und einem Eingang (e1, e1g) der Differenzverstärkerstufe (6) schließt,
**dadurch gekennzeichnet,**
**daß** zur Arbeitspunkteinstellung der Differenzverstärkerstufe (6) eine Diode (11) des gleichen Leitfähigkeitstyps wie der Leitfähigkeitstyp des als Schalter (3) dienenden Transistors vorgesehen ist.

2. Komparator nach Anspruch 1,
**dadurch gekennzeichnet,**
**daß** die Diode eine NMOS-Diode (11) ist.

3. Komparator nach Anspruch 1 oder 2,
**dadurch gekennzeichnet,**
**daß** die Diode zwischen Gate des Sourcefolger-Transistors (7) und der Versorgungsspannung (VSS) liegt.

## Claims

1. Comparator for a wide supply voltage range, in which a source follower (7) is connected downstream of a differential amplifier stage (6), and a switch (3) closes a feedback loop between an output (a1, q1) and an input (e1, e1q) of the differential amplifier stage (6), **characterized in that** a diode (11) which has the same conductivity type as the conductivity type of the transistor used as the switch (3) is provided in order to set the operating point of the differential amplifier stage (6).

2. Comparator according to Claim 1, **characterized in that** the diode is an NMOS diode (11).

3. Comparator according to Claim 1 or 2, **characterized in that** the diode is connected between the gate of the source follower transistor (7) and the supply voltage (VSS).

## Revendications

1. Comparateur pour grande gamme de tension d'alimentation, dans lequel il est monté une source suiveuse (7) en aval d'un étage (6) à amplificateur différentiel et un commutateur (3) ferme une boucle de réaction entre une sortie (a1, q1) et une entrée (e1, e1q) de l'étage (6) à amplificateur différentiel, **caractérisé en ce qu'**il est prévu pour le réglage du point de travail de l'étage (6) à amplificateur différentiel une diode (11) de même type de conductivité que le type de conductivité du transistor servant de commutateur (3).

2. Comparateur suivant la revendication 1,
**caractérisé en ce que** la diode est une diode (11) NMOS.

3. Comparateur suivant la revendication 1 ou 2,
**caractérisé en ce que** la diode se trouve entre la grille du transistor (7) à source suiveuse et la tension (VSS) d'alimentation.
